# EUROPÄISCHE PATENTSCHRIFT

(11) **EP 2 574 938 B1**
(45) Veröffentlichungstag und Bekanntmachung des Hinweises auf die Patenterteilung: **22.03.2017**
(21) Anmeldenummer: 12184885.7
(22) Anmeldetag: 18.09.2012
(51) Int. Cl.: G01R 31/02, H02H 3/00, G01R 27/18, G01R 35/00, G01R 31/12

(54) **Verfahren zur Isolationsfehlerüberwachung mit dynamischem Ansprechverhalten**
Method for insulation fault monitoring with dynamic response qualities
Procédé de surveillance des fauts d'isolation avec un rapport de réponse dynamique

(30) Priorität: 29.09.2011 DE 102011083790
(43) Veröffentlichungstag der Anmeldung: 03.04.2013
(73) Patentinhaber: Bender GmbH & Co. KG, 35305 Grünberg (DE)
(72) Erfinder: Möll, Winfried, 35321 Laubach (DE); Schepp, Karl, 35447 Reiskirchen (DE); Weiß, Carsten, 35321 Laubach-Lauter (DE)
(74) Vertreter: advotec.

(56) Entgegenhaltungen:
- EP-A1- 1 786 083
- DE-A1-102007 008 097
- US-A- 3 978 400
- US-A- 5 963 404
- US-A1- 2004 021 995
- US-A1- 2005 083 616
- US-A1- 2009 160 453

## Beschreibung

Die Erfindung betrifft ein Verfahren zur Isolationsfehlerüberwachung in ungeerdeten elektrischen Netzen, umfassend die Schritte: Messen eines Isolationswiderstands, Bestimmen eines Ansprechwertes für den Isolationswiderstand und Auslösen einer Warnmeldung, falls der gemessene Isolationswiderstand den Ansprechwert unterschreitet.

Des Weiteren betrifft die Erfindung ein Gerät zur Isolationsfehlerüberwachung in ungeerdeten elektrischen Netzen, mit Mitteln zur Messung eines Isolationswiderstands und einer Recheneinheit zur Bestimmung eines Ansprechwertes für den Isolationswiderstand sowie einer Warneinrichtung zur Auslösen einer Warnmeldung.

Im Hinblick auf die Betriebssicherheit und die Verfügbarkeit einer Stromversorgung haben sich ungeerdete Leitungsnetze (IT-Systeme) als Netzform weitgehend durchgesetzt. Bei ungeerdeten Leitungsnetzen ist kein aktiver Leiter direkt mit Erdpotential verbunden, so dass im Falle eines (einpoligen) Erdschlusses mangels Rückleitung kein Kurzschlussstrom fließen kann, der eine Sicherung auslöst und zu einer Betriebsunterbrechung führt. Ein ungeerdetes Netz kann trotz dieses Erdschlusses (erster Isolationsfehler) gefahrlos weiterbetrieben werden. Insbesondere bei Fotovoltaikanlagen (PV-Anlagen) ist diese Netzform weit verbreitet, da dort eine möglichst unterbrechungsfreie Energieversorgung im Vordergrund steht.

Vollkommen isolierte, ungeerdete Leitungsnetze bieten den bestmöglichen Schutz für Personen, falls diese einen spannungsführenden Leiter berühren, da wegen des im Idealfall unendlich großen Impedanzwertes zwischen Leiter und Erde kein geschlossener Stromkreis mit einem über die (geerdete) Person fließenden Strom entstehen kann. Zur Sicherstellung eines ausreichenden Personen- und Anlagenschutzes kommt daher dem Isolationswiderstand eine besondere Bedeutung zu. Ein Absinken des Isolationswiderstands unter einen vorgegebenen Wert vermindert den Schutz gegen direktes und indirektes Berühren der elektrischen Anlage; darüber hinaus können Fehlerströme auftreten und zu Fehlfunktionen elektrischer Einrichtungen oder zu einer hohe Kosten verursachenden Betriebsunterbrechung führen.

Im Bereich elektrischer Anlagen ist daher eine ständige Überwachung des Isolationswiderstandes erforderlich, um bei Unterschreiten eines sicherheitskritischen Ansprechwertes des Isolationswiderstands eine Warnmeldung auszugeben und gegebenenfalls die Anlage abzuschalten.

Isolationswiderstände können sich durch Alterungsprozesse und Umwelteinflüsse wie beispielsweise Temperatur, Feuchtigkeit, Verschmutzung oder Beschädigung sowie durch chemische oder physikalische Prozesse verändern. Gerade bei PV-Anlagen ist der Isolationswiderstand stark von den Umgebungsbedingungen der Anlage abhängig. So kann in Großanlagen der Isolationswiderstand im Bereich von 1000 Ohm/Volt bis zu wenigen Ohm/Volt schwanken. Dabei kann es zu Fehlauslösungen kommen, wenn umgebungsbedingt der Ansprechwert des Isolationswiderstands unterschritten wird. Um derartige Fehlauslösungen zu vermeiden, wird in Isolationsüberwachungssystemen dem Stand der Technik gemäß der Ansprechwert auf einen Wert deutlich unterhalb eines minimalen Isolationswiderstandswertes eingestellt. Als nachteilig erweist sich dabei, dass bereits oberhalb dieses (zu) niedrig eingestellten Ansprechwertes eine Personengefährdung eintreten kann.

Insbesondere in PV-Anlagen ändert sich der Isolationswiderstand auf Grund der Umgebungsbedingungen sehr stark auch ohne dass ein Fehlerfall eingetreten ist. Tritt in einer "hochohmigen Phase" - z.B. bei Fotovoltaikanlagen während der Nachtstunden - ein Isolationsfehler auf, findet also eine vom erwartungsgemäßen Verlauf deutlich abweichende Absenkung des aktuell gemessenen Isolationswiderstands statt, so kann dieser Isolationsfehler nur erkannt werden, wenn er auch unter den fest eingestellten niedrigen Ansprechwert sinkt.

Aus dem Stand der Technik sind Ansätze bekannt, durch statistische Mittelung die Änderung des Isolationswiderstands auf Grund der Umgebungsbedingungen zu berücksichtigen. Ein Nachteil bei dieser indirekten Einbeziehung der Umgebungsbedingungen sind aber lange Messzeiten des Isolationsüberwachungsgerätes.

In weiteren Veröffentlichungen finden sich Lösungsansätze, die einen variablen Schwellwert offenbaren.

So beschreibt das Dokument US 2009/160453 A1 ein Verfahren und eine Vorrichtung zur Erdschluss-(Fehler)-Erkennung in einem Stromsystem, das vorzugsweise mit einem Frequenz-Umrichter ausgestattet ist. Das Verfahren beruht auf der Erfassung und Überwachung eines Summenstroms an dem Ausgang des Frequenzumrichters, wobei der Schwellwert für den erfassten Summenstrom variabel an die Betriebsbedingungen und an die Netzwerk-Kenngrößen angepasst werden kann.

Dokument US 2004/021995 A1 zeigt ein System zur Erdschluss-(Fehler)-Erkennung in ungeerdeten Stromversorgungsnetzen. Das System weist eine besondere Empfindlichkeit zur Erkennung von Fehlerströmen auf. Die Messungen des Fehlerstroms und einer Fehlerspannung werden ausgewertet und daraus ein Fehlerwiderstand berechnet. Um zuverlässige Messergebnisse zu erzielen, kann entsprechend den Betriebsbedingungen zwischen zwei Messstellen umgeschaltet werden, wobei der erfasste Fehlerstrom mit einem umschaltbaren Schwellwert verglichen wird.

In Dokument US 2005/083616 A1 ist ein Mikrocontroller-basierter Schaltkreis mit einem Temperatur-kompensierten Sensor für eine Fehlerstrom-Schutzschaltung beschrieben. Der Schaltkreis eignet sich neben der Erfassung eines Fehlerstroms auch zur Erkennung einer Fehlerspannung.

Dokument US 3 978 400 A offenbart eine Fehlerstrom-Schutzeinrichtung für ungeerdete Stromversorgungssysteme. Die Fehlerstrom-Schutzeinrichtung weist eine elektrische Schaltung mit einem nichtlinear arbeitenden Stromsensor auf und kann Fehlerströme über einen weiten Pegelbereich detektieren.

Dokument US 5 963 404 A zeigt eine selektive Erdschluss-Schutzeinrichtung zum Schutz einer Transformatorwicklung. Die Bestimmung des Fehlerstroms erfolgt mittels zwei Stromwandlern, die den Leitungsabschnitt begrenzen, in dem die zu überwachende Transformatorwicklung angeordnet ist. Die Schutzeinrichtung weist weiter ein Richtungselement auf, welches die erfassten Summenströme auswertet.

Dokument DE 10 2007 008097 A1 zeigt ein sogenanntes Lastabnormalitäts-Detektionssystem und -verfahren, dessen Aufgabe es ist, sowohl den Kurzschluss als auch das Durchbrennen einer elektrischen Last zuverlässig zu erkennen. Diese Aufgabe wird im Wesentlichen durch eine Auswahleinrichtung gelöst, die selektiv entweder einen Durchbrenn-Referenzwert oder einen Kurzschluss-Referenzwert als Vergleichswert in einer Beurteilungsvorrichtung heranzieht und damit eine sichere Detektion/Beurteilung der beiden Abnormalitätsfälle Durchbrennen und Kurzschluss ermöglichen soll.

Dokument EP 1 786 083 A1 beschreibt ein Verfahren und ein System zur Überwachung von Leistungstransformatoren. Die Erkennung von Fehlerbedingungen erfolgt modellbasiert, wobei die durch Sensoren erfassten Messwerte mit aus den Modellen gewonnen adaptiven Schwellwerten verglichen werden.

Keines der bekannten Verfahren berücksichtigt die Umgebungsdaten in umfassender Weise, um einen hohen Personen- und Anlagenschutz mit hoher Betriebssicherheit sicherzustellen.Der vorliegenden Erfindung liegt somit die Aufgabe zu Grunde, unter Vermeidung von Fehlauslösungen einen möglichst zuverlässigen Personen- und Anlagenschutz sowie eine hohe Betriebssicherheit bei der Isolationsüberwachung eines ungeerdeten Stromversorgungsnetzes zu gewährleisten.

Diese Aufgabe wird in Verbindung mit dem Oberbegriff des Anspruchs 1 dadurch gelöst, dass der Ansprechwert als ein momentaner Ansprechwert dynamisch in einer der Isolationswiderstandsmessung nachgeschalteten Warnwert-Ermittlung bestimmt wird.

Somit wird bei der Isolationsfehlerüberwachung dem aktuell gemessenen Isolationswiderstand erfindungsgemäß ein sich dynamisch ändernder momentaner Ansprechwert als Vergleichswert gegenüber gestellt. Dieser Ansprechwert wird in einer der Isolationswiderstandsmessung nachgeschalteten Warnwert-Ermittlung bestimmt und erlaubt die automatische Anpassung des Ansprechwertes an die zum Messzeitpunkt vorherrschenden Umweltbedingungen. So liegt üblicherweise während der Nachtstunden der gemessene Isolationswiderstand auf einem höheren Niveau als tagsüber. Auch der Ansprechwert folgt erfindungsgemäß dieser Tendenz, so dass ein Fehlerfall - ein auffälliges Absinken des aktuellen, gemessenen Isolationswiderstands - mit größerer Zuverlässigkeit erkannt wird, weil der dynamisch nach oben angepasste Ansprechwert früher unterschritten wird. Tagsüber hingegen - bei relativ niedrigem Niveau des Isolationswiderstands - werden durch einen ebenfalls niedriger liegenden Ansprechwert Fehlauslösungen vermieden. Die Vermeidung von Fehlauslösungen führt zu einer erhöhten Betriebs- und damit Versorgungssicherheit der elektrischen Anlage. Zugleich werden der Anlagen- und besonders der Personenschutz auf Grund des dynamisch angepassten Ansprechwertes verbessert, weil Fehlerfälle frühzeitig erkannt werden.

Weiterhin wird der momentane Ansprechwert in der Warnwert-Ermittlung als Funktion von einem Basiswert, von Einstellparametern, von Umgebungsdaten und von einem zeitlich gemittelten Isolationswiderstandswert bestimmt. Ausgehend von einem anlagenspezifischen Isolationswiderstand als Basiswert ergibt sich der momentane Ansprechwert durch die Modifikation dieses Basiswertes entsprechend den Umgebungsdaten. So erfolgt beispielsweise eine Anpassung in Abhängigkeit der Zeit, der Temperatur und der Luftfeuchte, da erfahrungsgemäß eine Betauung in morgendlichen Stunden Einfluss auf den Isolationswiderstand hat. Durch die direkte Einbeziehung der Umgebungsdaten werden kurze Messzeiten und daraus folgend ein erhöhter Personenschutz erreicht.

Weiterhin gehen Einstellparameter und ein zeitlich gemittelter Isolationswiderstandswert in die Bestimmung des momentanen Ansprechwertes ein, um die Betriebsbedingungen der Anlage auf einen realitätsnahen Ansprechwert abzubilden, der zu einer möglichst zuverlässigen Fehlererkennung führt. So werden Grenzwerte für den Ansprechwert festgelegt und es wird dessen Änderung in Bezug auf einen zeitlichen Mittelwert des Isolationswiderstands berücksichtigt.

Der Basiswert ist ein für das zu überwachende Netz spezifischer, fester Wert des Isolationswiderstands. Als Ausgangspunkt für die Berechnung des momentanen Ansprechwerts wird somit ein für die elektrische Anlage typischer Isolationswiderstandswert verwendet, der sich aus einer formelmäßigen Berechnung ergibt.

Als Einstellparameter werden ein Mindestansprechwert Rₘᵢₙ als unterer Ansprech-Grenzwert, ein Hilfswert Ansprechwertdynamik R_{ADY} zur Festlegung eines Dynamikbereiches, in dem sich der momentane Ansprechwert dynamisch ändern darf und ein Hilfswert Ansprechwertgrenzen R_{LIM} zur Bestimmung einer Differenz des momentanen Ansprechwertes von dem zeitlich gemittelten Isolationswiderstandswert herangezogen.

Der momentane Ansprechwert bestimmt sich ausgehend von dem Basiswert R_{B} durch eine Korrektur in Abhängigkeit der Umgebungsdaten, wobei der momentane Ansprechwert minimal den Mindestansprechwert Rₘᵢₙ und maximal den Wert Ansprechwertdynamik R_{ADY} annimmt und innerhalb dieses Dynamikbereiches wenigstens um die Differenz Ansprechwertgrenzen R_{LIM} unterhalb des zeitlich gemittelten Isolationswiderstandswertes liegt.

Die Einstellparameter geben dabei den Bereich vor, in welchem der momentane Ansprechwert variieren darf und legen fest, wie der momentane Ansprechwert an die Betriebssituation der elektrischen Anlage anzupassen ist, um eine zuverlässige Fehlererkennung sicherzustellen.

Mit Vorteil ermöglicht ein derart dynamisch bestimmter Ansprechwert die rechtzeitige Erkennung einer "wahren" Absenkung des Isolationswiderstands.

Als Umgebungsdaten werden folgende Einflussgrößen einzeln oder in beliebiger Kombination miteinander in die Warnwert-Ermittlung einbezogen: Zeit, Lichtstärke, Temperatur, Luftfeuchtigkeit, Betauung, Salzgehalt der Luft, Änderungsgeschwindigkeit des Isolationswiderstands, Anzahl der anwesenden Personen im Bereich der elektrischen Anlage sowie bei Anwendung des Verfahrens in Fotovoltaikanlagen zusätzlich: elektrische Leitfähigkeit der Modulglasoberfläche, gelieferte Spannung der Fotovoltaik-Module, elektrische Leistung der Fotovoltaik-Module. Darüber hinaus können noch weitere physikalische Größen und Umweltdaten über geeignete Schnittstellen mitberücksichtigt werden, um einen an die jeweils vorherrschende Betriebssituation noch exakter angepassten momentanen Ansprechwert zu bestimmen. Damit werden auch kritische Änderungen des Isolationswiderstands zu jedem Zeitpunkt in einer Vielzahl von Betriebssituation erkannt.

In weiterer Ausgestaltung wird in Abhängigkeit des momentanen Ansprechwertes ein optisch und/oder akustisch wahrnehmbares Signal des Überwachungszustands erzeugt, das darüber informiert, ob Anlagen- oder Personenschutz gewährleistet ist. Damit erhält der Betreiber der elektrischen Anlage eine Aussage darüber, bis zu welchem Grad die im Vergleich zum reinen Anlagenschutz höheren Anforderungen an den Personenschutz momentan erfüllt sind.

Bei besonders stabilen Umgebungs- und Betriebsbedingungen kann die dynamische Bestimmung des momentanen Ansprechwertes deaktiviert werden und in einen Modus mit starrem Ansprechwert zurückgegangen werden.

Bezogen auf ein Gerät zur Isolationsfehlerüberwachung in ungeerdeten elektrischen Netzen wird die der Erfindung zu Grunde liegende Aufgabe in Verbindung mit dem Oberbegriff des Anspruchs 9 dadurch gelöst, dass die Recheneinheit zur Bestimmung des Ansprechwertes eine der Isolationswiderstandsmessung nachgeschaltete Warnwert-Ermittlungseinheit zur dynamischen Bestimmung eines momentanen Ansprechwertes aufweist.

Die Recheneinheit umfasst erfindungsgemäß eine Warnwert-Ermittlungseinheit, in der die Eingangssignale auf digitaler Ebene verarbeitet werden. Aus den Eingangsgrößen, die neben dem aktuell gemessenen Isolationswiderstand und den Einstellparametern die Umgebungsdaten umfassen, wird nach dem erfindungsgemäßen Verfahren der momentane Ansprechwert dynamisch bestimmt und durch Vergleich mit dem aktuellen Isolationswiderstandswert im Fehlerfall eine Warnmeldung generiert.

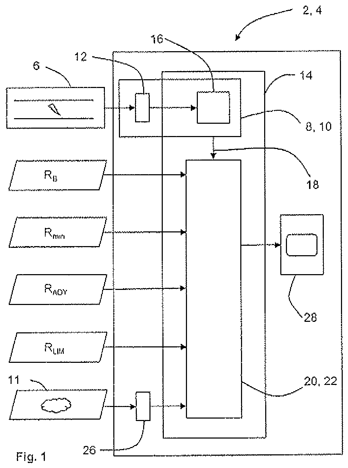

Weitere vorteilhafte Ausgestaltungsmerkmale ergeben sich aus der nachfolgenden Beschreibung und der Zeichnung, die eine bevorzugte Ausführungsform der Erfindung erläutert. Es zeigt die
- **Fig. 1**: ein funktionales Blockdiagramm des Verfahrens und des Gerätes zur Isolationsfehlerüberwachung.

Das in **Fig.1** dargestellte Diagramm beschreibt neben den wesentlichen Verarbeitungsschritten des erfindungsgemäßen Verfahrens 2 auch die wesentlichen funktionalen Blöcke des erfindungsgemäßen Gerätes 4.

Das Verfahren umfasst zunächst eine Isolationswiderstandsmessung 8 in einem ungeerdeten Stromversorgungsnetz 6. Das Stromversorgungsnetz 6 kann beispielsweise eine Fotovoltaik-Anlage sein, bei der eine effiziente Nutzung und eine hohe Verfügbarkeit im Vordergrund stehen und daher eine Überwachung des Isolationswiderstands als elektrische Schutzmaßnahme geboten erscheint. Das Gerät 4 weist Mittel 10 zur Messung eines Isolationswiderstands auf, wobei diese Mittel 10 über eine Ankopplungs- und Messschaltung 12 mit dem Stromversorgungsnetz 6 verbunden sind und als Bestandteil einer Recheneinheit 14 eine Auswerteschaltung 16 umfassen.

Die Isolationswiderstandsmessung 8 bzw. die Mittel 10 zur Messung des Isolationswiderstands liefern als Ausgangssignal einen aktuellen Wert 18 des Isolationswiderstands und geben diesen an eine Warnwert-Ermittlung 20 weiter, die in einer Warnwert-Ermittlungseinheit 22 ausgeführt wird.

In der Warnwert-Ermittlung 20 bzw. der Warnwert-Ermittlungseinheit 22 wird die Berechnung des momentanen Ansprechwertes ausgeführt. Zu der erfindungsgemäßen dynamischen Ermittlung des momentanen Ansprechwertes werden ein Basiswert R_{B}, als Einstellparameter ein Mindestansprechwert Rₘᵢₙ als unterer Ansprech-Grenzwert, ein Hilfswert Ansprechwertdynamik R_{ADY} zur Festlegung eines Dynamikbereiches, in dem sich der momentane Ansprechwert dynamisch ändern darf und ein Hilfswert Ansprechwertgrenzen R_{LIM} zur Bestimmung einer Differenz des momentanen Ansprechwertes von einem zeitlich gemittelten Isolationswiderstandswert herangezogen. Des Weiteren fließen Umgebungsdaten 24 in die dynamische Bestimmung mit ein. Die Umgebungsdaten beschreiben die Abhängigkeit des Isolationswiderstands von dem Betriebszustand der elektrischen Anlage, der wiederum von maßgeblich von äußeren Umwelteinflüssen (z.B. Temperatur, Luftfeuchtigkeit), physikalischen Größen der Anlage (z.B. erzeugte Leistung, Leerlaufspannung) und weiteren nicht physikalischen Parametern (z.B. anwesende Personen im Bereich der Anlage) bestimmt wird. Zur Erfassung der Umgebungsdaten weist das Gerät 4 eine Schnittstelleneinrichtung 26 auf.

Der momentane Ansprechwert bestimmt sich dann ausgehend von dem Basiswert R_{B} durch eine Korrektur in Abhängigkeit der Umgebungsdaten, wobei der momentane Ansprechwert minimal den Mindestansprechwert Rₘᵢₙ und maximal den Wert Ansprechwertdynamik R_{ADY} annimmt und innerhalb dieses Dynamikbereiches wenigstens um die Differenz Ansprechwertgrenzen R_{LIM} unterhalb des zeitlich gemittelten Isolationswiderstandswertes liegt.

Die Bestimmung des momentanen Ansprechwertes sei nachfolgend an dem Beispiel einer Fotovoltaikanlage erläutert. Beträgt der zeitlich gemittelte Isolationswiderstand bei der fehlerfreien Fotovoltaikanlage am Tag bei geringer Luftfeuchte/bei Nacht/in den Morgenstunden bei Betauung 10kOhm/200kOhm/80kOhm und werden als Einstellparameter die Werte Rₘᵢₙ = 3kOhm, R_{ADY} = 100kOhm und R_{LIM} = 20kOhm angenommen, so werden bei aktivierter Dynamik auch Fehlerfälle oberhalb von 3kOhm, bis maximal 100kOhm erkannt. Bei einem starren Ansprechwert von 3kOhm hingegen nur dann, wenn im Fehlerfall der aktuelle Wert des Isolationswiderstands 3kOhm unterschreitet.

Ein auftretender Fehler, also ein Unterschreiten des dynamisch bestimmten Ansprechwertes durch den aktuellen Isolationswiderstandswert würde also in dem Beispiel bei Tag/bei Nacht/ in den Morgenstunden bei 3kOhm/100kOhm/60kOhm (mit 60kOhm = 80kOhm-R_{LIM}) angezeigt werden.

Unterschreitet im Fehlerfall der gemessene Isolationswiderstand den Ansprechwert, so wird in der Warneinrichtung 28 eine Warnmeldung ausgelöst und dem Benutzer optisch und/oder akustisch signalisiert.

## Patentansprüche

1. Verfahren (2) zur Isolationsfehlerüberwachung in ungeerdeten elektrischen Netzen (6), umfassend die folgenden Schritte
- Messen eines Isolationswiderstands (8, 18) des ungeerdeten elektrischen Netzes,
- Bestimmen eines Ansprechwertes für den Isolationswiderstand (14),
- Auslösen einer Warnmeldung, falls der gemessene Isolationswiderstand (18) den Ansprechwert unterschreitet (14, 28),
- wobei der Ansprechwert als ein momentaner Ansprechwert dynamisch in einer der Isolationswiderstandsmessung nachgeschalteten Warnwert-Ermittlung (20) bestimmt wird, **dadurch gekennzeichnet, dass** der momentane Ansprechwert in der Warnwert-Ermittlung (20) als Funktion von einem Basiswert (R_{B}), von Einstellparametern (Rₘᵢₙ, R_{ADY}, R_{LIM}), von Umgebungsdaten (24) und von dem zeitlich gemittelten Isolationswiderstandswert bestimmt wird, und
der Basiswert (R_{B}) ein für das zu überwachende Netz (6) spezifischer, fester Wert des Isolationswiderstands ist, und
als Einstellparameter ein Mindestansprechwert (Rₘᵢₙ) als unterer Ansprech-Grenzwert, ein Hilfswert Ansprechwertdynamik (R_{ADY}) zur Festlegung eines Dynamikbereiches, in dem sich der momentane Ansprechwert dynamisch ändern darf und ein Hilfswert Ansprechwertgrenzen (R_{LIM}) zur Bestimmung einer Differenz des momentanen Ansprechwertes von dem zeitlich gemittelten Isolationswiderstandswert herangezogen werden, und wobei sich der momentane Ansprechwert ausgehend von dem Basiswert (R_{B}) durch eine Korrektur in Abhängigkeit der Umgebungsdaten (24) bestimmt, wobei der momentane Ansprechwert minimal den Mindestansprechwert (Rₘᵢₙ) und maximal den Wert Ansprechwertdynamik (R_{ADY}) annimmt und innerhalb dieses Dynamikbereiches wenigstens um die Differenz Ansprechwertgrenzen (R_{LIM}) unterhalb des zeitlich gemittelten Isolationswiderstandswertes liegt,
und
als Umgebungsdaten (24) folgende Einflussgrößen einzeln oder in beliebiger Kombination miteinander in die Warnwert-Ermittlung (20) einbezogen werden: Zeit, Lichtstärke, Temperatur, Luftfeuchtigkeit, Betauung, Salzgehalt der Luft, Änderungsgeschwindigkeit des Isolationswiderstands, Anzahl der anwesenden Personen im Bereich der elektrischen Anlage sowie bei Anwendung des Verfahrens in Fotovoltaikanlagen zusätzlich: elektrische Leitfähigkeit der Modulglasoberfläche, gelieferte Spannung der Fotovoltaik-Module, elektrische Leistung der Fotovoltaik-Module.

2. Verfahren nach Anspruch 1,
**dadurch gekennzeichnet,**
**dass** in Abhängigkeit des momentanen Ansprechwertes ein optisch und/oder akustisch wahrnehmbares Signal (28) des Überwachungszustands erzeugt wird, das darüber informiert, ob Anlagen- oder Personenschutz gewährleistet ist.

3. Verfahren nach Anspruch 1 oder 2,
**dadurch gekennzeichnet,**
**dass** die dynamische Bestimmung des momentanen Ansprechwertes deaktiviert werden kann.

4. Gerät zur Ausführung des Verfahrens zur Isolationsfehlerüberwachung in ungeerdeten elektrischen Netzen (6) nach Anspruch 1, mit Mitteln (10) zur Messung eines Isolationswiderstands und einer Recheneinheit (14) eingerichtet zur Bestimmung eines Ansprechwertes für den Isolationswiderstand sowie einer Warneinrichtung (28) zum Auslösen einer Warnmeldung,
**dadurch gekennzeichnet,**
**dass** die Recheneinheit (14) eine der Isolationswiderstandsmessung nachgeschaltete Warnwert-Ermittlungseinheit (22) eingerichtet zur dynamischen Bestimmung eines momentanen Ansprechwertes aufweist.

5. Gerät nach Anspruch 4,
**gekennzeichnet durch**
eine Schnittstelleneinrichtung (26) zur Erfassung von Umgebungsdaten (24).

## Claims

1. A method (2) for insulation fault monitoring in unearthed electrical networks (6), said method comprising the following steps:
- measuring an insulation resistance (8, 18) of the unearthed electrical network,
- determining a responding value for the insulation resistance (14),
- triggering a warning signal if the measured insulation resistance (18) falls below the responding value (14, 28),
- wherein the responding value is determined dynamically as a momentary responding value in a warning value establishment process (20) downstream of the insulation resistance measurement,
**characterized in that**
- the momentary responding value is determined in the warning value establishment process (20) as a function of a base value (R_{B}), of setting parameters (Rₘᵢₙ, R_{ADY}, R_{LIM}), of ambient data (24) and of an insulation resistance value averaged over time, and
- the base value (R_{B}) is a specific, fixed value of the insulation resistance for the network (6) to be monitored,
and
- the following are used as setting parameters: a minimum responding value (Rₘᵢₙ) as a lower response limit value, an auxiliary value in the form of a responding value dynamic (R_{ADY}) for defining a dynamic range in which the momentary responding value may change dynamically, and an auxiliary value in the form of responding value limits (R_{LIM}) for determining a difference of the momentary responding value from the insulation resistance value averaged over time, and wherein
- the momentary responding value is determined starting from the base value (R_{B}) by a correction according to the ambient data (24), wherein the momentary responding value adopts the minimum responding value (Rₘᵢₙ) at its minimum and the value in the form of a responding value dynamic (R_{ADY}) at its maximum and, within this dynamic range, lies below the insulation resistance value averaged over time, at least by the difference of the responding value limits (R_{LIM}), and
- the following influencing variables are incorporated as ambient data (24), either individually or in any combination, into the warning value establishment process (20): time, light intensity, temperature, atmospheric moisture, dew, salt content of the air, speed of change of the insulation resistance, number of people present in the region of the electrical plant, and additionally, with use of the method in photovoltaic plants: electrical conductivity of the module glass surface, supplied voltage of the photovoltaic modules, electrical output of the photovoltaic modules.

2. The method according to claim 1,
**characterized in that**
a visually and/or acoustically perceptible signal (28) of the monitoring state is generated according to the momentary responding value and informs whether plant or personal protection is ensured.

3. The method according to claim 1 or 2,
**characterized in that**
the dynamic determination of the momentary responding value can be deactivated.

4. A device for executing insulation fault monitoring in unearthed electrical networks (6) according to claim 1, said device comprising means (10) for measuring an insulation resistance, and a processor unit (14) for determining a responding value for the insulation resistance as well as a warning device (28) for triggering a warning signal,
**characterized in that**,
the processor unit (14) has a warning value establishment unit (22) downstream of the insulation resistance measurement to dynamically determine a momentary responding value.

5. The device according to claim 4,
**characterized by**
an interface device (26) for detecting ambient data (24).

## Revendications

1. Procédé (2) pour la surveillance de défaut d'isolement dans des réseaux électriques non mis à la terre (6), ledit procédé comprenant les étapes suivants:
- mesurer une résistance d'isolement (8, 18) du réseau électrique non mis à la terre,
- déterminer une valeur de fonctionnement pour la résistance d'isolement (14),
- déclencher un signal d'avertissement si la résistance d'isolement (18) mesurée tombe dessous la valeur de fonctionnement (14, 28),
- dans lequel la valeur de fonctionnement est déterminée dynamiquement quand une valeur de fonctionnement momentanée dans un processus de création de valeur d'avertissement (20) en aval de la mesure de résistance d'isolement,
**caractérisé en ce que**
- la valeur de fonctionnement momentanée est déterminée dans le processus de création de valeur d'avertissement (20) comme une fonction d'une valeur de base (R_{B}), des paramètres de réglage (Rₘᵢₙ, R_{ADY}, R_{LIM}), des données ambiantes (24) et d'une valeur de résistance d'isolement moyennée au cours de temps, et
- la valeur de base (R_{B}) est une valeur de résistance d'isolement spécifique et fixée le pour réseau (6) à être surveillé, et
- les suivants sont utilisés comme des paramètres de réglages: une valeur de fonctionnement (Rₘᵢₙ) minimum comme une valeur de réponse de limite basse, une valeur auxiliaire dans la forme d'une valeur de fonctionnement dynamique (R_{ADY}) pour définir une plage dynamique dans laquelle la valeur de fonctionnement momentanée peut être changée dynamiquement, et la valeur auxiliaire dans la forme d'une valeur de fonctionnement de limite (R_{LIM}) pour déterminer une différence de la valeur de fonctionnement momentanée de la valeur de résistance d'isolement moyennée au cours de temps, et dans lequel
- la valeur de fonctionnement momentanée est déterminée à partir de la valeur de base (R_{B}) par une correction selon les données ambiantes (24), dans lequel la valeur de fonctionnement momentanée adopte la valeur de fonctionnement (Rₘᵢₙ) minimum à son minimum et la valeur dans la forme d'une valeur de fonctionnement dynamique (R_{ADY}) à son maximum et, dans cette plage dynamique, est dessous la valeur de résistance d'isolement moyennée au cours de temps, au moins par la différence de la valeur de fonctionnement de limite (R_{LIM}), et
- les variables influant suivants sont incorporés comme des données ambiantes (24), individuellement ou bien dans n'importe quelle combinaison, dans le processus de création de valeur d'avertissement (20): le temps, l'intensité lumineuse, la température, l'humidité atmosphérique, la rosée, le contenu de sel de l'air, la vitesse de changement de la résistance d'isolement, le nombre des personnes qui sont présents dans la région de l'installation électrique, et en outre, quand le procédé est utilisé dans des installations photovoltaïques: la conductivité électrique de la surface de verre de module, le voltage alimenté des modules photovoltaïques, la sortie électrique des modules photovoltaïques.

2. Procédé selon la revendication 1,
**caractérisé en ce que**
un signal (28) perceptible visuellement et/ou acoustiquement de l'état surveillé est produit selon la valeur de fonctionnement momentanée et indique si la protection de l'installation ou des personnes est assurée.

3. Procédé selon la revendication 1 ou 2,
**caractérisé en ce que**
la détermination dynamique de la valeur de fonctionnement momentanée peut être désactivée.

4. Dispositif pour exécuter la surveillance de défaut d'isolement dans des réseaux électriques non mis à la terre (6) selon la revendication 1, ledit dispositif comprenant des moyens (10) pour mesurer une résistance d'isolement et une unité de calcul (14) pour déterminer la valeur de fonctionnement pour la résistance d'isolement ainsi qu'un dispositif d'avertissement (28) pour déclencher un signal d'avertissement,
**caractérisé en ce que**,
l'unité de calcul (14) a une unité de création de valeur d'avertissement (22) en aval de la mesure de résistance d'isolement pour détermine dynamiquement une valeur de fonctionnement momentanée.

5. Dispositif selon la revendication 4,
**caractérisé par**
un dispositif d'interface (26) pour détecter des données ambiantes (24).
